# EUROPEAN PATENT APPLICATION

(11) **EP 1 608 030 A2**
(43) Date of publication of application: **21.12.2005**
(21) Application number: 05105015.1
(22) Date of filing: 08.06.2005
(51) Int. Cl.: H01L 33/00

(54) **Light emitting device with transparent submount having backside vias**

(30) Priority: 14.06.2004 US 867606
(71) Applicant: Lumileds Lighting U.S., LLC, San Jose, California 95131 (US)
(72) Inventor: LUDOWISE, Michael, J.,c/o Lumileds Lighting US LLC, San Jose,CA California 95131 (US)
(74) Representative: van der Veer, Johannis Leendert

(57) **Abstract**

A device includes a semiconductor light-emitting device with contacts on the same side of the device and is mounted on a transparent submount having conductive vias that are electrically connected to the contacts in a flip-chip configuration. A method of producing a semiconductor light-emitting device includes producing a light emitting active region disposed between a first region of first conductivity type and a second region of second conductivity type on a growth substrate. A contact region is etched through the second region, the active region, and partially through the first region. Contacts are produced on the first region, i.e., in the etched contact region, and on the second region. A transparent submount with conductive vias is provided and bonded to the assembly before the growth substrate is removed. The submount and assembly are then diced together resulting in the submount and assembly having approximately the same footprint.

## Description

### FIELD OF THE INVENTION

The present invention relates to semiconductor light emitting devices and, in particular, to light emitting devices mounted to submounts.

### BACKGROUND

Semiconductor light emitting devices such as light emitting diodes (LEDs) are among the most efficient light sources currently available. Material systems currently of interest in the manufacture of high brightness LEDs capable of operation across the visible spectrum include group III-V semiconductors, particularly binary, ternary, and quaternary alloys of gallium, aluminum, indium, and nitrogen, also referred to as III-nitride materials; and binary, ternary, and quaternary alloys of gallium, aluminum, indium, and phosphorus, also referred to as III-phosphide materials. Such devices typically have a light emitting or active region sandwiched between a p-doped region and an n-doped region. Often III-nitride devices are epitaxially grown on sapphire, silicon carbide, or III-nitride substrates and III-phosphide devices are epitaxially grown on gallium arsenide by metal organic chemical vapor deposition (MOCVD) molecular beam epitaxy (MBE) or other epitaxial techniques.

A disadvantage of III-phosphide devices that are grown on gallium arsenide (GaAs) substrates is that the bandgap energy of GaAs is smaller than that of the III-phosphide material. As a result, the emission efficiency of an AlGaInP-GaAs device is significantly reduced. Attempts to solve this problem include bonding a support substrate to the epitaxy layers and removing the GaAs substrate. By way of example, mirrored or transparent support substrates may be used, such as that described in R.H. Horng, et al., "AlGaInP light-emitting diodes with mirror substances fabricated by wafer bonding", Appl. Phys. Lett. Vol. 75, No.20, 15 November 1999, pp 3054-3056 and Shoou-Jinn Chang et al., "AlGaInP-Sapphire Glue Bonded Light-Emitting Diodes", IEEE Journal of Quantum Electronics, Vol. 38, No. 10, October 2002, pp. 1390-1394. Such devices, however, have contacts formed on the side of the device through which light is extracted. Wire bonds are then used to connect the contacts of the device with a submount. Unfortunately, the heat transfer through the wire bonds is poor, and thus, additional heat sinking structures are typically required. In addition, the submount includes leads that are connected to the wire bonds. Accordingly, the footprint of the submount is typically much larger than the light-emitting device. Thus, the resulting device has large footprint relative to the light emitting area of the device.

### SUMMARY

According to an embodiment of the present invention, a device includes a semiconductor light emitting device with contacts formed on the same side of the device and is mounted on a transparent submount having conductive vias that are electrically connected to the contacts in a flip-chip configuration. A method of producing a semiconductor light-emitting device includes producing a light emitting active region disposed between a first region of first conductivity type and a second region of second conductivity type on a growth substrate. A contact region is etched through the second region, the active region, and partially through the first region. Contacts are produced on the first region, i.e., in the etched contact region, and on the second region. A transparent submount with conductive vias is provided and bonded to the assembly before the growth substrate is removed. The submount and assembly are then diced together resulting in a device with a small footprint.

### BRIEF DESCRIPTION OF THE DRAWINGS

Fig. 1A is a cross sectional view of an LED, in accordance with an embodiment of the present invention.
Fig. 1B illustrates a p-contact for the device illustrated in Fig. 1A.
Fig. 1C illustrates an n-contact for the device illustrated in Fig. 1A.
Fig. 2 illustrates a method of forming an III-phosphide LED according to Fig. 1A.

### DETAILED DESCRIPTION

In accordance with an embodiment of the present invention, a semiconductor light-emitting device is mounted on a transparent submount with conductive vias, which advantageously permit assembly without wire bonds. The presence of conductive vias in the transparent submount enables the production of a device with a flip-ship configuration, i.e., where the p and n contacts are formed on the same side of the device and light is extracted through the side of the device that is opposite the contact side. Accordingly, light extraction is improved. Moreover, the conductive vias provide an efficient means of heat transfer. The transparency of the submount permits easy alignment of the conductive vias with the contacts on the device, and thus, the submount may be bonded to the light-emitting device at the wafer level. The bonded light emitting device and submount can then be diced together in a single operation. Accordingly, the resulting device includes a submount with a footprint that is approximately the same size as the footprint of the light-emitting device.

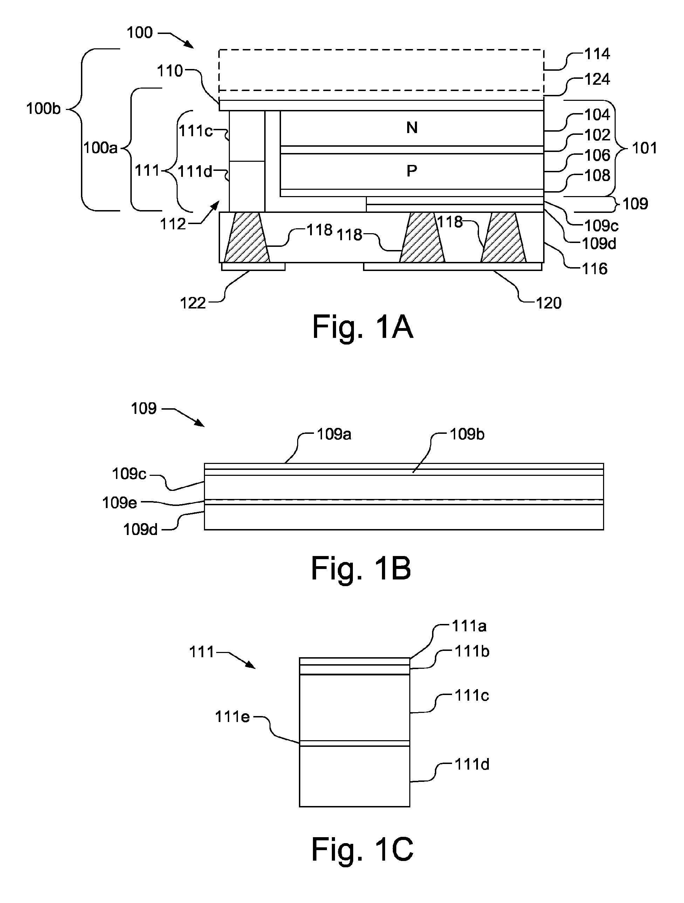

Fig. 1A is a cross sectional view of a device 100 that includes a semiconductor light emitting device 100a (sometimes referred to herein as LED 100a) mounted to a transparent submount 116 with conductive vias 118, in accordance with an embodiment of the present invention. The LED 100a includes a number of epitaxially grown layers 101, including a light emitting active region 102 sandwiched between an n-doped cladding region 104 and a p-doped cladding region 106. The wavelength of light emitted by the active region 102 may be controlled by selecting the width and composition of the layers in active region 102, as is well known in the art. An example of a suitable active region includes 3 or 4 quantum wells separated by barrier layers. The LED 100a also includes a p contact layer 108 in contact with the p-doped cladding region 106 and an n contact layer 110 in contact with the n-doped cladding region 104.

The epi layers 101 are grown on a GaAs substrate 114, which as illustrated by the broken lines in Fig. 1A is removed after the transparent submount 116 is mounted to the assembly 100b, which will be described below. Once the GaAs substrate 114 is removed, an anti-reflective coating 124 may be deposited over the epi layers 101 if desired. The anti-reflective coating 124 may be produced, e.g., as a quarter wavelength layer of SiNₓ, SiO₂, or MgO, or complex multilayer dielectric films as are well known in the art. Alternatively, the contact layer 110 may be treated, e.g., by roughening, to enhance optical extraction.

The table below gives examples of the approximate thicknesses, composition, and dopants appropriate for each layer in the epi layer 101. The characteristics given below for each layer are examples and are not meant to be limiting. More information on selecting the appropriate characteristics of the layers of the device may be found in chapters 1-3 of Semiconductors and Semimetals, Volume 64, Electroluminescence I, Academic Press, San Francisco, 2000, Gerd Mueller, ed., which is incorporated herein by reference.

| **Layer** | **Approx. Thickness** | **Material** |
|---|---|---|
| N-doped contact layer 110 | 0.5µm | InGaP:Te |
| N-doped cladding layer 104 | 1.5µm | AlInP:Te |
| Quantum wells of active region 102 | 125Å | AlInGaP undoped |
| Barrier layers of active region 102 | 125 Å | AlInP undoped |
| P-doped cladding region 106 | 1.5µm | AlInP:Mg |
| P-doped contact layer 108 | 500Å to 2µm | GaInP:Mg (or GaP:Mg) |

The p contact layer 108 is electrically coupled to a metal contact 109 and n contact layer 110 is electrically coupled to another metal contact 111. Contacts 109 and 111 are illustrated in Figs. 1B and 1C, respectively. Fig. 1B illustrates an example of a multilayer p-contact 109, which includes a metal p contact 109a of, e.g., AuZn alloy, having a thickness of approximately 2000Å, which provides ohmic contact to the semiconductor p contact layer 108. If desired, an adhesive layer of, e.g., titanium or nickel, may be deposited over the p contact layer 108 prior to depositing the ohmic layer 109a. The ohmic layer 109a is protected by a guard metal layer 109b of, for example, a sandwich of TiW, TiW:N, and TiW. The ohmic layer 109a and guard layer 109b may cover all or just a portion of the exposed p contact layer 108. A thick contact layer 109c, such as Ti/Au, having a thickness of approximately 2µm, is then formed over the guard layer 109b and may be used for bonding to the submount 116. Alternatively, as illustrated in Fig. 1B, a barrier layer 109e, e.g., of Ni or TiW, and a thick solder layer 109d, such as AuSn solder, is formed over all or a portion of the contact layer 109c. The solder layer 109d should be compliant to provide a suitable surface for soldering with the submount 116. If desired, a dielectric material, such as SiNx or Al₂O₃, may be deposited across the active region and p/n junction for passivation and protection.

Similarly, the n contact 111 may be formed with multiple layers, as illustrated in Fig. 1C. As illustrated in Fig. 1A, the LED 100 may have a flip chip architecture, and thus, the n contact 111 is formed within an n contact region 112 that extends from the submount 116 to the n contact layer 110. An ohmic layer 111a, e.g., of Au-Ge alloy, having a thickness of approximately 2000Å is formed to provide ohmic contact to the semiconductor n contact layer 110. If desired, an adhesive layer (not shown) of, e.g., titanium or nickel, may be deposited over the n contact layer 110 prior to depositing the ohmic layer 111a. The ohmic layer 111a is protected by a guard layer 111b of, e.g., a sandwich of TiW, TiW:N, and TiW. The ohmic layer 111a and guard layer 111b may cover all or just a portion of the exposed n contact layer 110. A thick contact layer 111c, such as TiAu, is then formed over the guard layer 111b and may be used for bonding to the submount. Alternatively, as illustrated in Fig. 1C, a barrier layer 111e and a thick solder layer 111d, such as AuSn, is formed over the contact layer 111c. The bonding layer 111d should be compliant to provide a suitable surface for bonding with the submount 116.

As illustrated in Fig. 1A, a transparent submount 116 with conductive vias is bonded to the epi layers 101. The submount 116 is, e.g., a glass substrate that includes a plurality of vias 118 of electrically and thermally conductive material. The submount 116 substrate may also be formed from other materials that are transparent or partially transparent at specific wavelengths of light, e.g., in the infrared (IR) or visible spectrum, and that are electrically insulating. By way of example, the submount 116 may be formed with materials such as GaAs, which is transparent in the IR spectrum or silicon. The vias 118 may be filled with, e.g., highly doped semiconductor material, such as silicon, or alternatively with other electrically and thermally conductive materials such as metal, e.g., Au, or metal alloys.

The submount 116 may be, e.g., 10 mils thick, and the vias 118 may be approximately 100µm to 250µm in diameter with a pitch of 200-500µm. A suitable submount 116 with vias 118 can be manufactured to order by M/A-Com, located in Lowell, Massachusetts. In addition, submounts with conductive vias, their production and their general use with LEDs is disclosed in U.S. Serial No. 10/632,719, by Jerome C. Bhat et al., entitled "Mount for Semiconductor Light Emitting Device, filed July 31, 2003, which is assigned to the assignee of the present disclosure and entirety of which is incorporated herein by reference.

The submount 116 may have a layer of gold or AuSn solder (not shown) on the top surface, i.e., the surface that is bonded to the contacts 109 and 111. Of course, if a bonding layer of gold or AuSn is on the top surface of the submount 116, the p and n contact portions of the bonding layer should be electrically isolated. A conductive region 120, which may be, e.g., a solderable layer of gold or AuSn, is in electrical contact with vias 118 that are coupled to the p contact 109, and another conductive region 122 is in electrical contact with the vias 118 that are coupled to the n contact 111. The conductive regions 120 and 122 may be used to solder the submount to structure such as a board, without the use of wire bonds.

The use of transparent submount 116 with conductive vias 118 is advantageous because it simplifies alignment of the vias 118 with the contacts 109 and 111. Accordingly, the submount 116 can be bonded to the semiconductor light emitting device 100a at the wafer level, e.g., a plurality of semiconductor light emitting devices in a wafer are simultaneously bonded to a respective plurality of submounts in a wafer. The submount wafer 116 also then serves as mechanical support for the epi layers 101 during and after the GaAs substrate 114 removal. The bonded submounts and semiconductor light emitting devices can then be diced in a single operation. Thus, the footprint of the submount in the resulting device is no larger than the footprint of the semiconductor light-emitting device. Further, the conductive vias 118 through the submount 116 enable a flip-chip style LED, where the p and n contact layers 108 and 110 are formed on the same side of the semiconductor light emitting device 100a and light is extracted through the side of the device opposite the contact side, as illustrated in Fig. 1A. Accordingly, device 100 obviates the use of obscuring contacts and wire bonds on the emitting surface, thereby improving light extraction and improving heat transfer.

It should be understood that the embodiment illustrated in Fig. 1A is a III-phosphide device, however, other embodiments may be fabricated in other materials systems, such as III-nitride. In addition, in the embodiments described below, the location of the p- and n-type regions and contacts of the device may be reversed. Further, the above description is illustrative and not limiting and alternative thicknesses, materials, dopants, as well as additional or fewer layers may be used to produce an adequate semiconductor light-emitting device in accordance with the present invention.

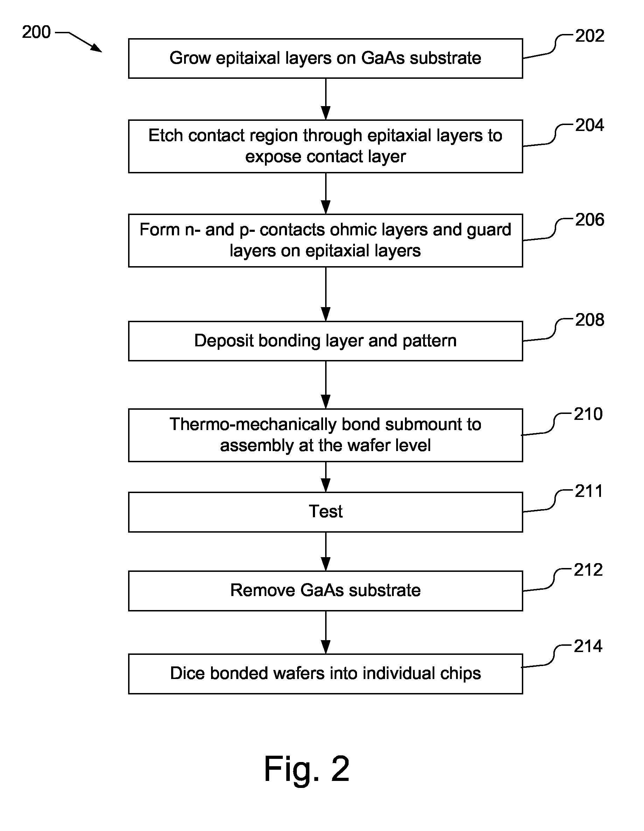

Fig. 2 illustrates a flow chart 200 of a method for forming the device 100 shown in Fig. 1A. First, in step 202, the epi layers 101 of the LED 100a are grown by, for example, metal organic chemical vapor deposition on GaAs substrate 114. The n contact layer 110 and cladding region 104 are grown first, followed by active region 102, cladding region 104 and p contact layer 108. After the p contact layer 108 is grown, the n contact region 112 is produced by etching through the p contact layer 108, the cladding region 106, the active region 102, and the cladding region 104 in order to expose the n contact layer 110 (step 204). The etching is stopped, e.g., either by chemical sensitivity or in a gas etch process by spectroscopic analysis of plasma.

The n and p metal layers, e.g., the contact ohmic layers and guard layers are then formed (step 206). First, ohmic contact layers 109a, 111a and then guard layers 109b, 111b are formed on the appropriate semiconductor layers and alloyed to the semiconductor layers by, for example, a rapid thermal anneal or anneal in a furnace. The bonding layers 111c (and layers 111e and 111d, if used) are then deposited and patterned to form the n contact 111 (step 208). The bonding layers 109c (and layers 109e and 109d, if used) are then deposited patterned to form the p contact 109. The deposition and patterning of one or more of the layers in the multiplayer contacts 109 and 111 may be performed together or separately. If desired, a dielectric material, such as SiNi or Al₂O₃, may be deposited around the n contact region 112 before or after the n contact 109 is deposited to serves as a protective and passivating layer.

The vias 118 in submount 116 are then aligned with the contacts 109 and 111, and thermo-mechanically bonded to the assembly 100b, illustrated in Fig. 1A. Alternatively, the vias 118 may be soldered to contacts 109 and 111. It should be understood that, at this point, the assembly 100b includes the GaAs growth substrate 114 along with the epitaxial grown layers 101, and the p and n contacts 109 and 111 (step 210). Thus, the assembly 100b and submount 116 are bonded at the wafer level, i.e., before the growth substrate 114 is removed. Accordingly, multiple semiconductor light emitting devices (in wafer form) are bonded to submounts (in wafer form) at the same time. The conductive regions 120 and 122 may be formed on the submount 116 prior to bonding the submount 116 to the assembly 100b.

The bonding of the submount 116 to the assembly 100b may be performed at 325°C for 1 to 5 minutes with a pressure of approximately 50 psi, if the bonding layers 109d and 111d are an AuSn solder. Forming gas or hydrogen atmosphere is preferred. If the bonding layers are gold, the bonding may be performed at 300-400° C at 100-800 psi for 1 to 10 minutes. A thermosonic scrubbing may be used to assist the bonding process.

Once the submount 116 is bonded to the assembly 100b, the devices may be tested at the wafer level (step 211), if desired. With the flip-chip configuration illustrated in Fig. 1A, the testing is performed by probing from the back side and sensing from the topside. The GaAs growth substrate 114 can then be conventionally removed (step 212) using an appropriate selective etching, such as with a NH₄OH:H₂O₂ solution, which are well known in the art. The individual LED chips are then diced (step 214). The anti-reflective coating 124, if used, may be deposited prior to dicing the wafer. It should be understood that the anti-reflective coating 124 may be one of several well known extraction enhancement films, such as a Brightness Enhancement Film, produced by 3M, or may be a surface treatment, e.g., roughening, of the semiconductor contact layer 110 to enhance optical extraction. The devices may then be packaged as desired.

Because the submount 116 and LED 100a are mounted at the wafer level and diced together, the footprint of the resulting device 100 is small. As can be seen in Fig. 1A, the footprint of the submount 116 is approximately the same as the footprint of the LED 100a. It should be understood that the footprint size of the submount 116 may vary slightly from the footprint size of the LED 100a, e.g., where the LED 100a is beveled, which can be done with a shaped blade during dicing. By way of comparison, conventionally the LED chips and submounts are separately diced and individually mounted. Such conventionally formed devices require the use of submounts with footprints that are substantially larger than the footprint of the LED chips in order to accommodate the necessary leads. There are also associated manufacturing costs with individual chip bonding that are eliminated by the present invention.

Having described the invention in detail, those skilled in the art will appreciate that, given the present disclosure, modifications may be made to the invention without departing from the spirit of the inventive concept described herein. For example, though the embodiment described above is a III-phosphide device, some embodiments may be applied to III-nitride devices. Therefore, it is not intended that the scope of the invention be limited to the specific embodiments illustrated and described.

## Claims

1. A device comprising:
a semiconductor light emitting device comprising:
an n-type layer;
a p-type layer;
an active region disposed between the n-type layer and the p-type layer;
an n-contact electrically connected to the n-type layer; and
a p-contact electrically connected to the p-type layer;
wherein the n- and p-contacts are formed on a same side of the semiconductor light emitting device;
a transparent submount comprising a plurality of vias extending through the transparent submount, the vias being electrically and thermally conductive, the n-contact of the semiconductor light emitting device is electrically and physically connected to at least one via and the p-contact of the semiconductor light emitting device is electrically and physically connected to at least one other via in a flip-chip configuration.

2. The device of Claim 1, wherein the semiconductor light-emitting device has a footprint and the transparent submount has approximately the same footprint.

3. The device of Claim 1, wherein the semiconductor light emitting device includes a bottom surface and the transparent submount includes a top surface that is connected to the bottom surface of the semiconductor light emitting device, wherein the top surface of the transparent submount and the bottom surface of the semiconductor light emitting device have the same dimensions.

4. The device of Claim 1, wherein the transparent submount is selected from the group including glass, GaAs, and silicon.

5. The device of Claim 1, wherein the plurality of vias is selected from the group including highly doped semiconductor material, metal, and metal alloys.

6. The device of Claim 5, wherein the highly doped semiconductor material is silicon.

7. The device of Claim 1, wherein the transparent submount includes a top surface to which the semiconductor light emitting device is connected and a bottom surface, the transparent submount further comprising a first conductive region and a second conductive region on the bottom surface of the transparent submount, the first conductive region is electrically connected to the at least one via connected to the n-contact, and the second conductive region is electrically connected to the at least one via connected to the p-contact.

8. The device of Claim 1, wherein the semiconductor light emitting device is one of a III-phosphide and III-nitride device.

9. The device of Claim 8, wherein the semiconductor light emitting device is one of an AlInGaP and InGaN device.

10. A device comprising:
a semiconductor light emitting device comprising a light emitting region disposed between a region of a first conductivity and a region of a second conductivity, the semiconductor light emitting device having a first surface; and
a transparent submount comprising a plurality of vias extending through the transparent submount, the vias being electrically and thermally conductive, the transparent submount having a top surface that is bonded to the first surface of the semiconductor light emitting device, wherein at least one via is electrically connected to the region of a first conductivity and at least one other via is electrically connected the region of a second conductivity, wherein the top surface of the transparent submount and the first surface of the semiconductor light emitting device have the same dimensions.

11. The device of Claim 10, wherein the semiconductor light emitting device further comprises a first contact disposed between the at least one via and the region of a first conductivity and a second contact disposed between the at least one other via and the region of a second conductivity.

12. The device of Claim 11, wherein the first contact and the second contact are formed on the same side of the semiconductor light-emitting device.

13. The device of Claim 10, wherein the transparent submount is formed from a material selected from the group including glass, GaAs, and silicon.

14. The device of Claim 10, wherein the plurality of vias is formed from a material selected from the group including highly doped silicon, metal, and metal alloys.

15. A method of producing a semiconductor light emitting device, the method comprising:
producing an assembly comprising a light emitting region disposed between a region of a first conductivity and a region of a second conductivity;
producing a first contact in electrical contact with the region of a first conductivity;
producing a second contact in electrical contact with the region of a second conductivity;
providing a transparent submount with a plurality of conductive vias, the conductive vias being electrically and thermally conductive; and
bonding the assembly to the transparent submount wherein at least one conductive via is in electrical contact with the first contact and at least one conductive via is in electrical contact with the second contact.

16. The method of Claim 15, wherein the assembly further comprises a growth substrate, the method further comprising:
removing the growth substrate after bonding the assembly to the transparent submount; and
dicing the bonded transparent submount and assembly after removing the growth substrate to produce a semiconductor light emitting device.

17. The method of Claim 15, wherein the assembly and transparent submount are bonded at the wafer level and are diced together.

18. The method of Claim 15, wherein producing an assembly comprises:
producing a first contact layer on a growth substrate;
producing a first cladding layer on the first contact layer, the first cladding layer being the region of a first conductivity type;
producing an active region over the first cladding layer, the active region being the light emitting region;
producing a second cladding layer over the active region, the second cladding layer being the region of a second conductivity type;
producing a second contact layer on the second cladding layer;
etching a contact region through the second contact layer, the second cladding layer, the active region and the first cladding layer, wherein the first contact is produced in the contact region.

19. The method of Claim 18, further comprising depositing a dielectric material in the contact region with the first contact.

20. The method of Claim 18, wherein the second contact is at least partially reflective of light emitted from the active region.

21. The method of Claim 18, further comprising depositing an anti-reflective coating over the first contact layer after removing the growth substrate.
